# EUROPÄISCHE PATENTSCHRIFT

(11) **EP 3 158 350 B1**
(45) Veröffentlichungstag und Bekanntmachung des Hinweises auf die Patenterteilung: **11.04.2018**
(21) Anmeldenummer: 15727629.6
(22) Anmeldetag: 03.06.2015
(51) Int. Cl.: G01R 31/00, G01R 31/36

(54) **SYSTEM UND VERFAHREN ZUR ÜBERWACHUNG EINER NICKEL-CADMIUM-BATTERIE IN EINEM PASSAGIERFLUGZEUG**
SYSTEM AND METHOD FOR MONITORING A NICKEL CADMIUM BATTERY IN A PASSENGER AIRCRAFT
SYSTÈME ET PROCÉDÉ DE SURVEILLANCE D'UNE BATTERIE NICKEL-CADMIUM DANS UN AVION DE PASSAGERS

(30) Priorität: 19.06.2014 DE 102014211797
(43) Veröffentlichungstag der Anmeldung: 26.04.2017
(73) Patentinhaber: Lufthansa Technik AG, 22335 Hamburg (DE)
(72) Erfinder: SPERLING, Florian, 23866 Nahe (DE); GÜTTLER, Andrej, 22305 Hamburg (DE)
(74) Vertreter: Müller Verweyen
(86) Internationale Anmeldenummer: PCT/EP2015/062343
(87) Internationale Veröffentlichungsnummer: WO 2015/193109

(56) Entgegenhaltungen:
- WO-A1-2013/084353
- DE-A1-102010 041 024
- DE-A1-102012 222 721
- US-A- 5 939 861
- US-A1- 2011 172 939
- US-A1- 2013 207 462
- US-B1- 6 504 344

## Beschreibung

Die Erfindung betrifft ein System und ein Verfahren zur Überwachung einer Nickel-Cadmium-Batterie mit zwanzig in Reihe geschalteten Nickel-Cadmium-Batteriezellen in einem Passagierflugzeug.

Die Batterien (Main Batteries) eines Passagierflugzeugs sind wichtiger Bestandteil des bordeigenen Energieversorgungssystems. Seit Jahrzehnten werden hierfür wieder aufladbare Nickel-Cadmium-Batterien mit einer Nennspannung von 24 Volt verwendet, die aus einer Reihenschaltung von zwanzig Nickel-Cadmium-Batteriezellen mit einer Nennspannung von jeweils 1.2 Volt bestehen. Die Batterien dienen beispielsweise zur elektrischen Versorgung in Notsituationen, bis andere redundante Stromquellen verfügbar sind; zum Starten der Hilfsgasturbine (APU); und zur Versorgung von Teilsystemen am Boden für Wartung und Flugvorbereitung. Dabei bestehen hohe Anforderungen an Sicherheit, Zuverlässigkeit und Verfügbarkeit, woraus vergleichsweise kurze Wartungsintervalle resultieren.

Derzeit werden die Batterien nach einer bestimmten Anzahl von Flugstunden (Flight Hours, FH) oder nach Ablauf eines definierten Zeitintervalls ausgebaut. Für die Feststellung des Zustandes und die Instandhaltung müssen die Batterien aus dem Flugzeug ausgebaut und in einer Werkstatt überholt werden.

Die Batteriehersteller geben in ihrer Dokumentation für die Wartungsintervalle hingegen stets Betriebsstunden (Operational Hours, OH) an. Da die Flugzeugbetreiber allerdings nur Flugstunden erfassen, ist über das folgende Verhältnis ein Faktor definiert: Faktor = OH/FH. Dieses Verhältnis darf, abhängig vom Einsatzprofil des Flugzeugs, in einem bestimmten Bereich schwanken. Das Einsatzprofil wird über das Verhältnis FH/FC berechnet, wobei FC die Flugzyklen (Flight Cycles) bezeichnet, und nach Kurz-, Mittel- bzw. Langstrecke klassifiziert. Somit wird ein Bezug zur Bodenzeit hergestellt.

Ein typischer Zyklus einer Flugzeugbatterie, die nach Ablauf des geltenden Zeitlimits ausgebaut wird, ist beispielsweise Lagerung - Einbau - Betrieb im Flugzeug - Ausbau - Instandhaltung - Lagerung. Maßnahmen, die während der Instandhaltung durchgeführt werden, sind beispielsweise: Periodischer Check, beispielsweise umfassend Isolationsmessung, Spannungsmessung und Füllstandmessung; Regulärer Check umfassend Periodischen Check und Kapazitätstest; Allgemeine Überholung (General Overhaul) umfassend Regulären Check und Reinigung.

Im Flugzeug werden herkömmlich lediglich die Gesamtspannung und der Lade- bzw. Entladestrom erfasst. Ferner wird bei einigen Batterietypen auch an einem zentral gelegenen Messpunkt eine Temperatur gemessen. Eine Auswertung bzw. Verknüpfung dieser Daten findet im Flugzeug nicht statt, wobei auf der Grundlage dieser Daten ohnehin keine zufriedenstellende Aussage über den Alterungszustand der Batterie getroffen werden kann.

In der Werkstatt wird der Gesundheitszustand (State of Health, SoH) einer Flugzeugbatterie, wie vom Hersteller im Component Maintenance Manual beschrieben, über die Isolationswerte, Zellenspannung bei Belastung, den Füllstand des Elektrolyts und die Kapazität ermittelt. An der Aussagekraft dieser Methode bezüglich des State of Health bestehen Zweifel. Wenn die Flugzeugbatterie den Kapazitätstest ohne Probleme besteht, wird sie unabhängig vom Betriebszustand einzelner Zellen als betriebsfähig gekennzeichnet und kann somit im Flugzeug verbaut werden. Geschwächte Zellen bleiben so unerkannt und werden im fortlaufenden Betrieb weiter geschädigt. Wird der Fehler im Rahmen der Instandhaltung später erkannt, ist die Batterie aufgrund einer geringen Anzahl von fehlerhaften Batteriezellen, beispielsweise fünf, zu entsorgen. In jedem Fall werden Schwachstellen bzw. potentielle Fehler an einer im Einsatz befindlichen Batterie, wenn überhaupt, frühestens während der Instandhaltung in der Werkstatt erkannt und behoben. Es handelt sich somit um schlafende Fehler; eine frühzeitige bzw. rechtzeitige Erkennung dieser Fehler ist nicht möglich. Demnach können auch keine vorbeugenden Maßnahmen getroffen werden, um einer irreparablen Schädigung und damit einhergehenden Notwendigkeit einer endgültigen Außerbetriebnahme einzelner Batteriezellen bzw. der gesamten Batterie entgegenzuwirken.

Aus einer derart vorgeschädigten Batterie kann schlimmstenfalls die im Notfall erforderliche Kapazität, die eine Notstromversorgung für 30 Minuten sicherstellen soll, nicht entnommen werden, was die Flugsicherheit beeinträchtigen kann.

Eine Analyse der Historie zeigt, dass es sich bei den im Flugzeug verwendeten Nickel-Cadmium-Batterien um sehr zuverlässige Komponenten handelt. Die Batterien werden daher verhältnismäßig viel zu häufig im intakten Zustand ausgebaut, wodurch unnötiger Aufwand entsteht. Eine Auswertung eines bestimmten Passagierflugzeugtyps im Jahre 2012 hat beispielsweise ergeben, dass nur ein bestimmter Anteil der ausgebauten Batterien einen schlafenden Fehler aufwiesen, welcher während des Betriebs im Flugzeug nicht erkannt wurde. Demnach wurde bei vielen ausgebauten Batterien kein Fehler gefunden, so dass deren Ausbau nicht erforderlich gewesen wäre.

Wird eine Batteriezelle mit der Zeit kontinuierlich schwächer, werden die anderen Batteriezellen stärker belastet und dadurch möglicherweise ebenso geschädigt. Von außen ist dieses Ungleichgewicht zwischen den einzelnen Batteriezellen nicht erkennbar. Selbst mit den vom Hersteller geforderten Tests werden geschwächte Batteriezellen nur unzureichend identifiziert. Dies resultiert in einem erhöhten und unnötigen Außerbetriebnahmeerfordernis ganzer Batterien, da zum Zeitpunkt der Feststellung des Fehlers bereits mehrere Batteriezellen einen massiven Defekt aufweisen können.

Ein weiterer Nachteil ist, dass es keinen einheitlichen Ausbaustandard für Batterien gibt. Jeder Betreiber legt in Abstimmung mit den Systementwicklern die Wartungsintervalle fest, nach denen eine Batterie ausgebaut werden soll. Als Grundlage dieser Entscheidung werden Erfahrungswerte und Herstellerempfehlungen herangezogen. Eine solide Datenbasis in Form von kontinuierlich erfassten Messwerten ist derzeit nicht vorhanden. Dies birgt ein Risiko in Bezug auf die Beurteilung des Alterungszustands der Batterien.

WO 2013/084353 A1, US 6,504,344 B1, DE 10 2010 041 024 A1 und US 2011/0172939 A1 offenbaren jeweils ein System zur Überwachung einer elektrochemischen Batterie mit wesentlichen Merkmalen des Oberbegriffs von Anspruch 1. US 2013/0207462 A1, DE 10 2012 222 721 A1 und US 5,939,861 offenbaren weitere Systeme zur Überwachung einer elektrochemischen Batterie.

Die Aufgabe der Erfindung besteht darin, ein System und ein Verfahren zur Überwachung einer Flugzeugbatterie bereitzustellen, die eine kostengünstige, effizientere Wartung und Instandhaltung ermöglichen, die durchschnittliche Betriebsdauer der Batterien sowie die Flugsicherheit erhöhen und die Zahl der irreparablen Batterieschädigungen verringern.

Die Erfindung löst diese Aufgabe mit den Merkmalen der unabhängigen Ansprüche.

Erfindungsgemäß ist eine Mehrzahl von Zellensensoren zur Messung der Zellenspannung und der Zellentemperatur der einzelnen Batteriezellen und eine Datenverarbeitungseinrichtung vorgesehen, wobei das System zur Messung des Batteriestroms eingerichtet ist, und wobei die Datenverarbeitungseinrichtung zur Ermittlung einer den Gesundheitszustand der Batterie kennzeichnenden Gesundheitszustandsgröße aus den Messdaten von den Zellensensoren und dem gemessenen Batteriestrom eingerichtet ist. Unter dem Batteriestrom ist die Stromstärke des zwischen den Batteriepolen fließenden Stroms zu verstehen. Mithilfe der Erfindung ist es möglich, eine kontinuierliche zellenbasierte Aussage über den aktuellen Alterungs- bzw. Gesundheitszustand (State of Health, SoH) einer Flugzeugbatterie zu treffen, so dass jederzeit eine genaue Kenntnis über den aktuellen Gesundheitszustand der Batterie vorliegt. Aufgrund der Erfindung müssen die Batterien nicht mehr zur regelmäßigen Überprüfung aus dem Flugzeug ausgebaut werden, sondern Ausbau und Instandhaltung erfolgen nur noch bei Bedarf (Maintenance On Demand) oder bei Anzeige eines Fehlers auf der Grundlage der erfindungsgemäß ermittelten Gesundheitszustandsgröße. Da etwaige Fehler oder Ermüdungen einzelner Batteriezellen erfindungsgemäß frühzeitig erkannt werden können, können schlafende Fehler im Flugbetrieb weitgehend vermieden werden, was zur Erhöhung der Flugsicherheit beiträgt. Aufgrund der Reduktion der Batterieausbauten ergibt sich eine erhebliche langfristige Kostensenkung. Die durchschnittliche Betriebsdauer zwischen zwei Ausbauvorgängen (Mean Time Between Removal, MTBR) kann signifikant erhöht werden. Aufgrund der frühzeitigen Fehlererkennung können ungesunde Batterien präventiv ausgetauscht und rechtezeitig instandgesetzt werden, bevor die Schädigung aufgrund weiterer Belastung irreparabel wird, wodurch die Zahl der erforderlichen endgültigen Außerbetriebnahmen bzw. Verschrottungen reduziert wird. Aufgrund der Kenntnis des Gesundheitszustands der einzelnen Batteriezellen wird die Fehlersuche vereinfacht, was eine schnellere und effizientere Instandhaltung und Wartung ermöglicht. Aufgrund der Erfindung kann schließlich ein einheitlicher objektiver Ausbaustandard für Flugzeugbatterien erreicht werden.

Zusätzlich zu der Gesundheitszustandsgröße besteht die Möglichkeit, aus den gemessenen Zellenspannungen den Ladezustand der einzelnen Batteriezellen (State of Charge, SoC) zu bestimmen.

Vorzugsweise ist jeder Batteriezelle der Batterie ein entsprechender Zellensensor zugeordnet, um eine differenzierte und zellengenaue Kenntnis des Gesundheitszustands der Batterie zu ermöglichen. Der Batteriestrom kann mit einer Strommesseinrichtung und/oder direkt mittels der Datenverarbeitungseinrichtung gemessen werden. Es kann damit bereits ein Fehlverhalten einzelner Zellen detektiert werden, obwohl der Gesamtzustand der Batterie noch zufriedenstellend ist. Es wird so ermöglicht, einen präventiven Wechsel der Batterie vorzunehmen, um so ein schwerwiegenderes Fehlverhalten zu vermeiden.

Vorteilhaft wird bei Belastung der Batterie, insbesondere bei Hochstrombelastung, der Innenwiderstand der einzelnen Zellen aus dem Verhältnis zwischen Zellenspannung und Batteriestrom berechnet. Besonders bei Hochstromereignissen, wie beispielsweise dem Starten einer Hilfsturbine des Flugzeugs, können aussagekräftige Messwerte aufgezeichnet werden, wie z.B. der Innenwiderstand der Batterie.

Die Datenverarbeitungseinrichtung ist vorzugsweise zur Berücksichtigung einer oder mehrerer der folgenden Parameter in der Berechnung der Gesundheitszustandsgröße eingerichtet: momentane Belastung der Batterie; aktueller Ladezustand der Batteriezellen; Temperatur der Batteriezellen; Anzahl der Ladezyklen; Anzahl der Betriebsstunden OH; Füllstände der Batteriezellen; Isolation der Batteriezellen. Denn diese Faktoren haben einen mehr oder weniger großen Einfluss auf den Innenwiderstand einer Nickel-Cadmium-Zelle. Dem liegt die Erkenntnis zugrunde, dass der Gesundheitszustand einer Batterie maßgeblich vom Innenwiderstand jeder einzelnen Batteriezelle abhängig ist.

Mittels des erfindungsgemäßen Batteriemanagementsystems können maßgebliche Einflussfaktoren entweder direkt erfasst oder durch geeignete Verknüpfung der erfassten bzw. aufgezeichneten Messwerte abgeleitet werden. So wird erfindungsgemäß der Füllstand einzelner Batteriezellen aus dem Ladestrom, der Zellenspannung und der Zellentemperatur ermittelt. Die Isolation einer Batteriezelle kann wiederum aus dem ermittelten Füllstand dieser Batteriezelle ermittelt werden. Zusätzlich oder alternativ kann die Isolation einer Batteriezelle durch Messung eines Leckstroms zwischen Batterieanschlüssen und Batteriegehäuse gemessen werden. Die Anzahl der Betriebsstunden OH und/oder die Zahl der Lade-/Entladezyklen der Batterie kann aus dem kontinuierlich gemessenen Lade-/Entladestrom der Batterie bestimmt werden.

Der ermittelte Gesundheitszustand ist vorzugsweise direkt an der Batterie ablesbar, wenn vorteilhaft eine Anzeige an der Batterie für die ermittelte Gesundheitszustandsgröße vorgesehen ist. Dies kann in einer einfachen Ausführungsform beispielsweise mittels einer Mehrzahl von, beispielsweise farblich, unterschiedlich kodierten Leuchtmitteln oder Leuchtzuständen geschehen. Zum anderen kann die Batterie im Flugzeug vorzugsweise an einen Kommunikationsbus (z.B. Maintenance Bus) angeschlossen sein, um die Gesundheitszustandsgröße oder darauf beruhende Informationen insbesondere an das Cockpit und/oder das bordeigene Diagnosesystem zu übertragen.

Besonders vorteilhaft sind die Zellensensoren und die Datenverarbeitungseinrichtung zur drahtlosen Kommunikation miteinander eingerichtet. Das erfindungsgemäße Batterieüberwachungssystem (Battery Monitoring System, BMS) besteht somit aus einem drahtlosen Sensornetzwerk, welches die Flugzeugbatterie kontinuierlich, z.B. in regelmäßigen Zeitabständen und/oder ereignisgesteuert, überwacht.

Vorzugsweise sind die Zellensensoren, die Strommesseinrichtung und/oder die Datenverarbeitungseinrichtung in die Batterie integriert bzw. in einem Batteriegehäuse angeordnet. Alternativ können die Zellensensoren auch in jeweils einer Batteriezelle angeordnet sein. Die Batterie ist dann eine eigenständige Einheit, die ohne Bezugnahme auf batterieexterne Einrichtungen des Flugzeugs selbstständig eine Aussage über ihren Gesundheitszustand treffen und diesen gegebenenfalls anzeigen kann.

Ein weiterer Aspekt der Erfindung betrifft ein Verfahren zur Überwachung einer Nickel-Cadmium-Batterie mit zwanzig in Reihe geschalteten Nickel-Cadmium-Batteriezellen in einem Passagierflugzeug, umfassend die Schritte: Messung der Zellenspannung und der Temperatur der einzelnen Batteriezellen, Messung des Batteriestroms, und Ermitteln einer den Gesundheitszustand der Batterie kennzeichnenden Gesundheitszustandsgröße aus den Messdaten in einer Datenverarbeitungseinrichtung.

Die Erfindung wird im Folgenden anhand bevorzugter Ausführungsformen unter Bezugnahme auf die beigefügten Figuren erläutert. Dabei zeigt:
- Fig. 1: eine schematische Zeichnung eines Passagierflugzeugs;
- Fig. 2: eine perspektivische Ansicht einer Flugzeugbatterie; und
- Fig. 3: eine schematische Darstellung einer Funkverbindung zwischen einer Batteriezelle und einer Datenverarbeitungseinrichtung.

Ein Passagierflugzeug 10 umfasst mindestens eine, in der Regel eine Mehrzahl von Flugzeugbatterien 11 (Main Batteries), die Teil des bordeigenen elektrischen Systems (Aircraft Electrical System) sind. Die Flugzeugbatterien 11 dienen insbesondere zum Starten eines Hilfstriebwerks 13 (Auxiliary Power Unit, APU) und gegebenenfalls eines Haupttriebwerks 12; auf dem Boden zur autarken Stromversorgung, wenn keine bodengestützte Stromversorgung zur Verfügung steht; und im Flug, wenn eine Fehlfunktion oder ein Ausfall der elektrischen Generatoren vorliegt.

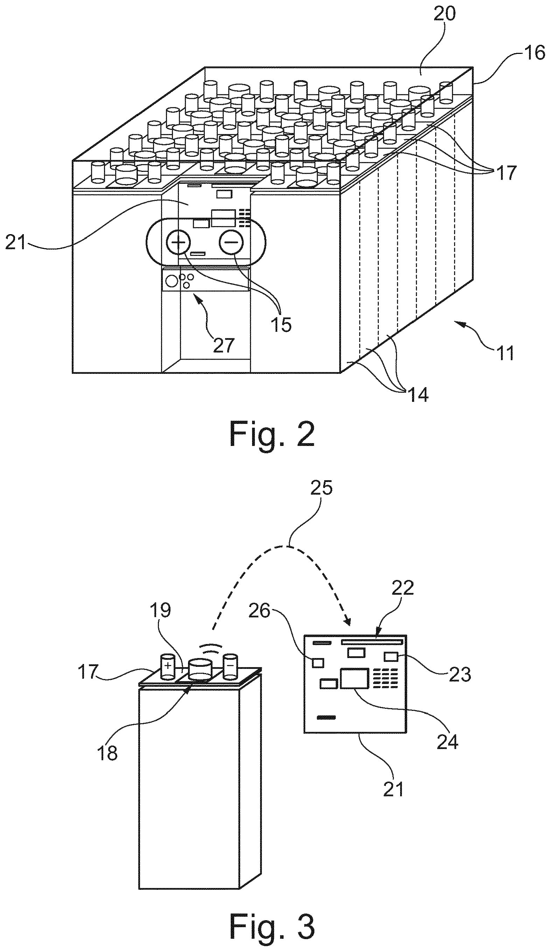

Eine erfindungsgemäße Nickel-Cadmium-Batterie 11 ist in Fig. 2 im Detail gezeigt. Die Flugzeugbatterie 11 umfasst zwanzig in Serie geschaltete Nickel-Cadmium-Batteriezellen 14, die hier beispielsweise in drei Reihen mit sieben-sechs-sieben Batteriezellen 14 angeordnet sind, ohne auf diese Anordnung beschränkt zu sein. Da eine Nickel-Cadmium-Batteriezelle 14 eine Nominalspannung von 1.2 V aufweist, ergibt sich aufgrund der Reihenschaltung eine Nominalspannung der Batterie 11 von 24 Volt. Die Batteriezellen 14 sind in einem beispielsweise kastenförmigen Batteriegehäuse 16 (Box) angeordnet, das üblicherweise mittels eines Deckels 20 verschließbar ist und beispielsweise eine Handhabe zum Tragen der Batterie 11 aufweist. Die Batterie 11 weist wie üblich zwei Batteriepole auf, die über entsprechende Anschlüsse 15 an dem Batteriegehäuse 16 mit einem Stromkabel verbindbar sind, um Strom aus der Batterie 11 zu entnehmen.

Jeder Batteriezelle 14 ist ein eigener Zellensensor 17 zugeordnet, der Sensorelemente zur Messung der Zellenspannung, d.h. der über der zugeordneten Batteriezelle 14 anliegenden Spannung, und zur Messung der Zellentemperatur, d.h. der in der zugeordneten Batteriezelle 14 herrschenden Temperatur, aufweist. Die Zellensensoren 17 sind somit dezentral, weil sie nicht der gesamten Batterie 11, sondern jeweils nur einer Batteriezelle 14 zugeordnet sind. Die Zellensensoren 17 können durch geeignete elektronische Bauteile auf einer Leiterplatte realisiert sein. Die Zellensensoren 17 sind vorzugsweise zur drahtlosen Kommunikation eingerichtet und umfassen daher vorzugsweise eine Funkantenne 18, die beispielsweise als Leiterplattenantenne ausgeführt ist, und ein mit der Funkantenne 18 verbundenes Funkmodul 19. Es handelt sich somit um drahtlose Zellensensoren 17. Die Zellensensoren 17 sind vorteilhaft innerhalb des Batteriegehäuses 16 angeordnet. Vorzugsweise können die Zellensensoren 17 auch über eine Kabelverbindung mit einer Datenerfassungs-/-verarbeitungseinrichtung 21 verbunden sein.

Die Batterie 11 umfasst des Weiteren die (batterie-)zentrale Datenerfassungs-/-verarbeitungseinrichtung 21, die einen Mikroprozessor oder Microcontroller 24 umfasst und zum Empfang der von sämtlichen Zellensensoren 17 gemessenen Daten eingerichtet ist. Die Datenerfassungs-/-verarbeitungseinrichtung 21 ist vorzugsweise zur drahtlosen Kommunikation mit den Zellensensoren 17 eingerichtet und umfasst zu diesem Zweck vorzugsweise eine Funkantenne 22 und ein mit der Funkantenne 22 verbundenes Funkmodul 23. In Fig. 3 ist beispielhaft die drahtlose Uplink-Funkverbindung 25 zwischen einem Zellensensor 17 und der Datenerfassungs-/-verarbeitungseinrichtung 21 gezeigt, wobei wie zuvor beschrieben sämtliche Zellensensoren 17 eine derartige Funkverbindung 25 zu der Datenerfassungs-/-verarbeitungseinrichtung 21 aufweisen. Die Datenerfassungs-/-verarbeitungseinrichtung 21 und die Zellensensoren 17 bilden somit ein drahtloses Sensornetzwerk.

Die Datenerfassungs-/-verarbeitungseinrichtung 21 kann durch geeignete elektronische Bauteile auf einer Leiterplatte, insbesondere in Form einer Datenerfassungs- und Berechnungskarte (Data Acquisition and Computation Card, DACC), realisiert sein. Die Datenerfassungs-/-verarbeitungseinrichtung 21 ist vorzugsweise innerhalb des Batteriegehäuses 16 angeordnet.

Die Batterie 11 umfasst des Weiteren eine Strommesseinrichtung 26, die vorzugsweise in der Datenerfassungs-/-verarbeitungseinrichtung 21 ausgebildet ist, insbesondere durch entsprechende elektronische Bauteile, und die zur Messung des durch die Batterie 11 fließenden (Gesamt-)Stroms eingerichtet ist. Die Strommesseinrichtung 26 kann in einer Ausführungsform auch zur Messung der Leckströme zwischen den Batterieanschlüssen 15 und dem Batteriegehäuse 16 eingerichtet sein.

Die Zellensensoren 17 messen dezentral und vorteilhaft kontinuierlich sowohl die Zellenspannung als auch die Temperatur der zugehörigen Batteriezelle 14 und übertragen diese Messwerte vorteilhaft drahtlos an die Datenerfassungs-/-verarbeitungseinrichtung 21. Die Strommesseinrichtung 26 misst zentral und vorteilhaft kontinuierlich den Batteriestrom. In einer Ausführungsform misst die Strommesseinrichtung 26 zusätzlich vorteilhaft kontinuierlich die zuvor beschriebenen Leckströme, insbesondere um daraus die Isolationswerte der Batterie 11 zu bestimmen.

Anhand sämtlicher vorteilhaft kontinuierlich zur Verfügung stehender Daten ermittelt die Datenerfassungs-/-verarbeitungseinrichtung 21 eine den Gesundheitszustand der Batterie 11 kennzeichnende Gesundheitszustandsgröße. Dies wird im Folgenden genauer erläutert.

Der Gesundheitszustand (State of Health, SoH) der Batterie 11 wird maßgeblich vom Innenwiderstand jeder einzelnen Batteriezelle 14 bestimmt. Bei Belastung der Batterie 11 kann der Innenwiderstand aus dem Verhältnis zwischen der von dem Zellensensor 17 gemessenen Zellenspannung und dem von der Strommesseinrichtung 26 gemessenen Gesamtstrom zu einem bestimmten Zeitpunkt errechnet werden. Besonders bei Hochstromereignissen, wie beispielsweise dem Starten der Hilfstriebwerke 13, können aussagekräftige Messwerte aufgezeichnet werden.

Beim Innenwiderstand von Batteriezellen handelt es sich um ein nicht-lineares und dynamisches System. Der Innenwiderstand der Nickel-Cadmium-Zellen 14 hängt mehr oder weniger stark insbesondere von folgenden Faktoren ab:
- momentane Belastung der Batterie 11;
- aktueller Ladezustand der Batteriezellen 14;
- Temperatur der Batteriezellen 14;
- Anzahl der Ladezyklen;
- Anzahl der Betriebsstunden OH;
- Füllstände der Batteriezellen 14;
- Isolation der Batteriezellen 14.

Vorteilhaft werden daher diese Faktoren für eine zuverlässige Bestimmung des Alterungszustands SoH der Batteriezellen 14 berücksichtigt. Mittels des zuvor beschriebenen Batteriemanagementsystems können die obigen Einflussfaktoren entweder direkt erfasst (momentane Belastung aus dem gemessenen Batteriestrom; aktueller Ladezustand einer Batteriezelle 14 aus der gemessenen Zellenspannung; Zellentemperatur) oder durch geeignete Verknüpfung der erfassten bzw. aufgezeichneten Messwerte abgeleitet werden:
- Der Füllstand der Batteriezellen 14 wird mit Hilfe des Stromes, der Zellenspannung und der Zellentemperatur bestimmt: Sobald eine Nickel-Cadmium-Zelle 14 überladen wird, kommt es zur Bildung von Wasserstoff und Sauerstoff, der aus der Zelle entweicht. Der Anteil an destilliertem Wasser im Elektrolyt reduziert sich, wodurch der Füllstand sinkt. Der Wasserverbrauch korreliert demnach mit der messtechnisch bestimmbaren Dauer einer Überladung.
- Die Isolation ist wesentlich von Elektrolytrückständen in Form von kristallinen Ablagerungen (Kaliumcarbonat) abhängig. Diese sorgen aufgrund ihrer Leitfähigkeit für Leckströme zwischen den Batterieanschlüssen 15 und dem Batteriegehäuse 16. Die Isolation kann indirekt über den ermittelten Füllstand oder optional messtechnisch ermittelt werden, wenn die Strommesseinrichtung 26 zur Messung der Leckströme eingerichtet ist.
- Die tatsächlichen Betriebsstunden (Operation Hours, OH), in denen die Batterie 11 belastet wird, können über den Lade- und Entladestrom gemessen werden. Somit besteht ein direkter Zusammenhang zu den Angaben des Batterieherstellers. Ferner besteht die Möglichkeit, eine Zählung der Lade- und Entladezyklen vorzunehmen.

Die ermittelte Gesundheitszustandsgröße wird in einer vorteilhaften Ausführungsform anhand mehrerer farbiger Leuchtmittel 27, die vorzugsweise außen am Batteriegehäuse 16 angeordnet sind, angezeigt. In einem Ausführungsbeispiel kann es sich um drei Leuchtmittel 27 unterschiedlicher Farbe handeln, etwa rote, orange und grüne LEDs. Wenn die Gesundheitszustandsgröße in einem mittleren Bereich liegt, zeigt die orange LED an, dass ein Tausch der Batterie 11 bei nächster Gelegenheit durchzuführen ist. Die rote LED zeigt dagegen an, dass die Batterie 11 nicht mehr flugtauglich ist und daher sofort zu wechseln ist, wenn die Gesundheitszustandsgröße einen kritischen Wert unterschreitet. Die grüne LED zeigt an, dass die Batterie 11 gesund ist, wenn die Gesundheitszustandsgröße oberhalb eines entsprechenden Grenzwerts liegt. Auch zwei Leuchtmittel 27 mit unterschiedlichen Farben (beispielsweise rot/grün) können ausreichen, ebenso können mehr als drei Farbkodierungen verwendet werden, um eine differenziertere Aussage über den Gesundheitszustand zu ermöglichen. Die Leuchtmittel 27 können beispielsweise von einem Wartungstechniker aktivierbar sein.

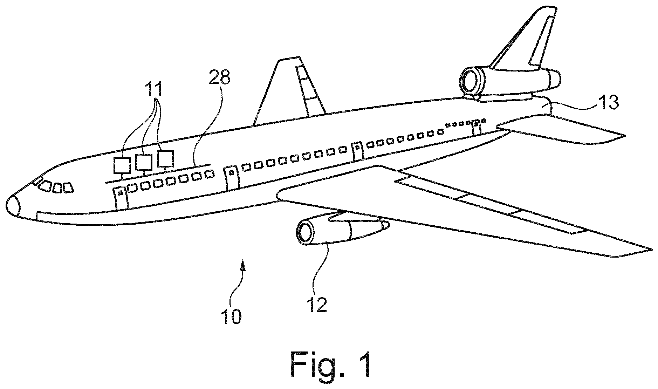

Eine weitere Möglichkeit besteht in einer Anbindung der Datenerfassungs-/-verarbeitungseinrichtung 21 an einen Datenbus 28 des Flugzeugs (siehe Fig. 1), beispielsweise ARINC 429. Die ermittelte Gesundheitszustandsgröße oder eine darauf beruhende Warnung kann dann beispielsweise an das Cockpit übermittelt werden.

Die Datenerfassungs-/-verarbeitungseinrichtung 21 kann ihre korrekte Funktion bzw. die des Batteriemanagementsystems vorteilhaft mittels einer Testeinrichtung (Built In Test Equipment, BITE) überwachen. Sendet beispielsweise ein Zellensensor 17 keine Daten, wird dies von der Datenerfassungs-/- verarbeitungseinrichtung 21 bemerkt und mittels einer entsprechenden Fehlermeldung angezeigt. Für die Fehlermeldung kann gegebenenfalls eines der Leuchtmittel 27, beispielsweise die orangene LED, genutzt werden.

## Patentansprüche

1. System zur Überwachung einer Nickel-Cadmium-Batterie (11) mit zwanzig in Reihe geschalteten Nickel-Cadmium-Batteriezellen (14) in einem Passagierflugzeug (10), wobei das System eine Mehrzahl von Zellensensoren (17) zur kontinuierlichen Messung der Zellenspannung und der Zellentemperatur einzelner Batteriezellen (14) und eine Datenverarbeitungseinrichtung (21) umfasst und zur kontinuierlichen Messung des Batteriestroms eingerichtet ist, wobei die Datenverarbeitungseinrichtung (21) zur Ermittlung einer den Gesundheitszustand der Batterie (11) kennzeichnenden Gesundheitszustandsgröße aus den Messdaten von den Zellensensoren (17) und dem gemessenen Batteriestrom eingerichtet ist, **dadurch gekennzeichnet, dass** der Füllstand einzelner Batteriezellen (14) aus dem Batteriestrom, der Zellenspannung und der Zellentemperatur ermittelt wird, wobei die Reduzierung des Anteils an destilliertem Wasser im Elektrolyten, und dadurch sinkender Füllstand, mit der messtechnisch zu bestimmenden Dauer einer Überladung korreliert.

2. System nach Anspruch 1, **dadurch gekennzeichnet, dass** jeder Batteriezelle (14) der Batterie (11) ein entsprechender Zellensensor (17) zugeordnet ist.

3. System nach Anspruch 1 oder 2, **dadurch gekennzeichnet, dass** bei Belastung, insbesondere bei Hochstrombelastung, der Innenwiderstand der einzelnen Batteriezellen (14) aus dem Verhältnis zwischen Zellenspannung und Batteriestrom berechnet wird.

4. System nach einem der vorangehenden Ansprüche, **dadurch gekennzeichnet, dass** die Datenverarbeitungseinrichtung (21) zur Berücksichtigung einer oder mehrerer der folgenden Parameter in der Berechnung der Gesundheitszustandsgröße eingerichtet ist:
- momentane Belastung der Batterie (11);
- aktueller Ladezustand der Batteriezellen (14);
- Temperatur der Batteriezellen (14);
- Anzahl der Ladezyklen;
- Anzahl der Betriebsstunden OH;
- Füllstände der Batteriezellen (14);
- Isolation der Batteriezellen (14).

5. System nach einem der vorangehenden Ansprüche, **dadurch gekennzeichnet, dass** die wesentlich von Elektrolytrückständen, die aufgrund ihrer Leitfähigkeit für Leckströme sorgen, abhängige Isolation einer Batteriezelle (14) aus dem Füllstand dieser Batteriezelle (14) ermittelt wird.

6. System nach einem der vorangehenden Ansprüche, **dadurch gekennzeichnet, dass** die Isolation der Batterie (11) aus einem gemessenen Leckstrom zwischen Batterieanschlüssen (15) und Batteriegehäuse (16) ermittelt wird.

7. System nach einem der vorangehenden Ansprüche, **dadurch gekennzeichnet, dass** die Anzahl der Betriebsstunden OH und/oder die Zahl der Lade-/Entladezyklen der Batterie (11) aus dem kontinuierlich gemessenen Lade-/Entladestrom der Batterie (11) bestimmt wird.

8. System nach einem der vorangehenden Ansprüche, **dadurch gekennzeichnet, dass** eine Anzeige (27) an der Batterie (11) für die ermittelte Gesundheitszustandsgröße vorgesehen ist.

9. System nach Anspruch 8, **dadurch gekennzeichnet, dass** die Anzeige (27) eine Mehrzahl in Abhängigkeit der Gesundheitszustandsgröße, beispielsweise farblich, unterschiedlich kodierter Leuchtmittel oder Leuchtzustände aufweist.

10. System nach einem der vorangehenden Ansprüche, **dadurch gekennzeichnet, dass** die Datenverarbeitungseinrichtung (21) zur Anbindung an einen Datenbus (28) des Flugzeugs (10) eingerichtet ist.

11. System nach einem der vorangehenden Ansprüche, **dadurch gekennzeichnet, dass** die Zellensensoren (17) und die Datenverarbeitungseinrichtung (21) zur drahtlosen Kommunikation miteinander eingerichtet sind.

12. System nach einem der vorangehenden Ansprüche, **dadurch gekennzeichnet, dass** die Batterie (11) eine Testeinrichtung zum Testen der korrekten Funktion des Systems umfasst.

13. System nach einem der vorangehenden Ansprüche, **dadurch gekennzeichnet, dass** die Zellensensoren (17), die Strommesseinrichtung (26) und/oder die Datenverarbeitungseinrichtung (21) innerhalb eines Batteriegehäuses (16) angeordnet sind.

14. Verfahren zur Überwachung einer Nickel-Cadmium-Batterie (11) mit zwanzig in Reihe geschalteten Nickel-Cadmium-Batteriezellen (14) in einem Passagierflugzeug (10), wobei das Verfahren die folgenden Schritte umfasst: kontinuierliche Messung der Zellenspannung und der Temperatur der einzelnen Batteriezellen (14), kontinuierliche Messung des Batteriestroms, und Ermitteln einer den Gesundheitszustand der Batterie (11) kennzeichnenden Gesundheitszustandsgröße aus den Messdaten in einer Datenverarbeitungseinrichtung (21), **dadurch gekennzeichnet, dass** der Füllstand einzelner Batteriezellen (14) aus dem Batteriestrom, der Zellenspannung und der Zellentemperatur ermittelt wird, wobei die Reduzierung des Anteils an destilliertem Wasser im Elektrolyten, und dadurch sinkender Füllstand, mit der messtechnisch zu bestimmenden Dauer einer Überladung korreliert.

## Claims

1. System for monitoring a nickel-cadmium battery (11) comprising twenty nickel-cadmium battery cells (14) connected in series in a passenger aircraft (10), wherein the system comprises a plurality of cell sensors (17) for continuously measuring the cell voltage and the cell temperature of individual battery cells (14) and a data processing unit (21), and said system is set up to continuously measure the battery current, the data processing unit (21) being set up to determine a state of health value which is indicative of the state of health of the battery (11) from the measurement data of the cell sensors (17) and the measured battery current, **characterised in that** the filling level of individual battery cells (14) is determined from the battery current, the cell voltage and the cell temperature, wherein the reduction of the proportion of distilled water in the electrolyte, and as a result a lowering filling level, correlates with the duration of overcharging to be determined by measurement.

2. System according to claim 1, **characterised in that** each battery cell (14) of the battery (11) is assigned a corresponding cell sensor (17).

3. System according to either claim 1 or claim 2, **characterised in that**, during loading, in particular during high-current loading, the internal resistance of the individual battery cells (14) is calculated from the ratio of cell voltage to battery current.

4. System according to any of the preceding claims, **characterised in that** the data processing unit (21) is set up to take into consideration one or more of the following parameters when calculating the state of health value:
- the instantaneous load of the battery (11);
- the current state of charge of the battery cells (14);
- the temperature of the battery cells (14);
- the number of charging cycles;
- the number of operational hours OH;
- the filling levels of the battery cells (14);
- the insulation of the battery cells (14).

5. System according to any of the preceding claims, **characterised in that** the insulation of a battery cell (14) that is substantially dependent on electrolyte residue, which owing to its conductivity results in leakage currents, is determined from the filling level of this battery cell (14).

6. System according to any of the preceding claims, **characterised in that** the insulation of the battery (11) is determined from a measured leakage current between the battery terminals (15) and the battery housing (16).

7. System according to any of the preceding claims, **characterised in that** the number of operational hours OH and/or the number of charging/discharging cycles of the battery (11) is determined from the continuously measured charging/discharging current of the battery (11).

8. System according to any of the preceding claims, **characterised in that** a display (27) is provided on the battery (11) for the determined state of health value.

9. System according to claim 8, **characterised in that** the display (27) has a plurality of lamps or luminous states which are differently coded, for example by colour, depending on the state of health value.

10. System according to any of the preceding claims, **characterised in that** the data processing unit (21) is set up for connection to a data bus (28) of the aircraft (10) .

11. System according to any of the preceding claims, **characterised in that** the cell sensors (17) and the data processing unit (21) are set up to communicate with one another wirelessly.

12. System according to any of the preceding claims, **characterised in that** the battery (11) comprises a test device for testing that the system is functioning properly.

13. System according to any of the preceding claims, **characterised in that** the cell sensors (17), the current measuring device (26) and/or the data processing unit (21) are arranged inside a battery housing (16).

14. Method for monitoring a nickel-cadmium battery (11) comprising twenty nickel-cadmium battery cells (14) connected in series in a passenger aircraft (10), wherein the method comprises the following steps: continuously measuring the cell voltage and the temperature of the individual battery cells (14), continuously measuring the battery current, and determining a state of health value which is indicative of the state of health of the battery (11) from the measurement data in a data processing unit (21), **characterised in that** the filling level of individual battery cells (14) is determined from the battery current, the cell voltage and the cell temperature, wherein the reduction of the proportion of distilled water in the electrolyte, and as a result a lowering filling level, correlates with the duration of overcharging to be determined by measurement.

## Revendications

1. Système de surveillance d'une batterie nickel-cadmium (11) comportant vingt cellules de batterie nickel-cadmium (14) branchées en série dans un avion de passagers (10), le système comprenant une pluralité de capteurs de cellule (17) destinés à la mesure en continu de la tension de cellule et de la température de cellule de cellules de batterie (14) individuelles et un moyen de traitement de données (21) et étant configuré pour la mesure en continu du courant de batterie, le moyen de traitement de données (21) étant configuré pour la détermination d'une grandeur d'état de santé caractérisant l'état de santé de la batterie (11) à partir des données de mesure des capteurs de cellule (17) et du courant de batterie mesuré, **caractérisé en ce que** le niveau de remplissage de cellules de batterie (14) individuelles est déterminé à partir du courant de batterie, de la tension de cellule et de la température de cellule, la réduction de la teneur en eau distillée dans l'électrolyte, et ainsi un niveau de remplissage en baisse, étant en corrélation avec la durée d'une surcharge à déterminer par la mesure.

2. Système selon la revendication 1, **caractérisé en ce qu'**à chaque cellule de batterie (14) de la batterie (11) est associé un capteur de cellule (17) correspondant.

3. Système selon la revendication 1 ou 2, **caractérisé en ce que**, lors d'une charge, en particulier une charge à courant de haute intensité, la résistance interne des cellules de batterie (14) individuelles est calculée à partir du rapport entre la tension de cellule et le courant de batterie.

4. Système selon l'une des revendications précédentes, **caractérisé en ce que** le moyen de traitement de données (21) est configuré pour la prise en compte d'un ou de plusieurs des paramètres suivants dans le calcul de la grandeur d'état de santé :
- charge momentanée de la batterie (11) ;
- état de charge actuel des cellules de batterie (14) ;
- température des cellules de batterie (14) ;
- nombre de cycles de charge ;
- nombre d'heures de service OH ;
- niveaux de remplissage des cellules de batterie (14) ;
- isolation des cellules de batterie (14).

5. Système selon l'une des revendications précédentes, **caractérisé en ce que** l'isolation d'une cellule de batterie (14), dépendante essentiellement de résidus d'électrolyte qui, en raison de leur pouvoir conducteur, entraînent des courants de fuite, est déterminée à partir du niveau de remplissage de cette cellule de batterie (14).

6. Système selon l'une des revendications précédentes, **caractérisé en ce que** l'isolation de la batterie (11) est déterminée à partir d'un courant de fuite mesuré entre les bornes de batterie (15) et le boîtier de batterie (16).

7. Système selon l'une des revendications précédentes, **caractérisé en ce que** le nombre d'heures de service OH et/ou le nombre de cycles de charge/décharge de la batterie (11) est déterminé à partir du courant de charge/décharge mesuré en continu de la batterie (11).

8. Système selon l'une des revendications précédentes, **caractérisé en ce qu'**une indication (27) est prévue sur la batterie (11) pour la grandeur d'état de santé déterminée.

9. Système selon la revendication 8, **caractérisé en ce que** l'indication (27) comporte une pluralité de moyens lumineux ou d'états lumineux codés différemment, par exemple par couleurs, en fonction de la grandeur d'état de santé.

10. Système selon l'une des revendications précédentes, **caractérisé en ce que** le moyen de traitement de données (21) est configuré pour la connexion à un bus de données (28) de l'avion (10).

11. Système selon l'une des revendications précédentes, **caractérisé en ce que** les capteurs de cellule (17) et le moyen de traitement de données (21) sont configurés pour la communication sans fil l'un avec l'autre.

12. Système selon l'une des revendications précédentes, **caractérisé en ce que** la batterie (11) comprend un moyen de test pour tester le fonctionnement correct du système.

13. Système selon l'une des revendications précédentes, **caractérisé en ce que** les capteurs de cellule (17), le moyen de mesure du courant (26) et/ou le moyen de traitement de données (21) sont disposés à l'intérieur d'un boîtier de batterie (16).

14. Procédé de surveillance d'une batterie nickel-cadmium (11) comportant vingt cellules de batterie nickel-cadmium (14) branchées en série dans un avion de passagers (10), le procédé comprenant les étapes suivantes : mesure en continu de la tension de cellule et de la température des cellules de batterie (14) individuelles, mesure en continu du courant de batterie, et détermination d'une grandeur d'état de santé caractérisant l'état de santé de la batterie (11) à partir des données de mesure dans un moyen de traitement de données (21), **caractérisé en ce que** le niveau de remplissage de cellules de batterie (14) individuelles est déterminé à partir du courant de batterie, de la tension de cellule et de la température de cellule, la réduction de la teneur en eau distillée dans l'électrolyte, et ainsi un niveau de remplissage en baisse, étant en corrélation avec la durée d'une surcharge à déterminer par la mesure.
